# EUROPEAN PATENT SPECIFICATION

(11) **EP 4 481 416 B1**
(45) Date of publication and mention of the grant of the patent: **04.11.2026**
(21) Application number: 23807887.7
(22) Date of filing: 16.05.2023
(51) Int. Cl.: G01R 31/392, G01R 31/3842, G01R 31/374, G01R 31/367, G01R 31/396, H01M 10/48, G01R 31/36

(54) **BATTERY SOH ESTIMATING APPARATUS AND METHOD**
VORRICHTUNG UND VERFAHREN ZUR SCHÄTZUNG DES BATTERIEZUSTANDS
APPAREIL ET PROCÉDÉ D'ESTIMATION DE L'ÉTAT DE SANTÉ D'UNE BATTERIE

(30) Priority: 18.05.2022 KR 20220060635
(43) Date of publication of application: 25.12.2024
(73) Proprietor: LG Energy Solution, Ltd., Seoul 07335 (KR)
(72) Inventor: JANG, Ji-Hoon, Daejeon 34122 (KR); SONG, Soo-Bin, Daejeon 34122 (KR); LEE, Gyu-Yeol, Daejeon 34122 (KR); HAN, Hyun, Daejeon 34122 (KR)
(74) Representative: Plasseraud IP
(86) International application number: PCT/KR2023/006640
(87) International publication number: WO 2023/224368

(56) References cited:
- EP-A1- 3 663 780
- EP-B1- 3 273 523
- JP-B2- 6 439 352
- KR-A- 20100 019 249
- KR-A- 20170 022 746
- KR-A- 20180 047 768
- KR-A- 20210 089 021
- KR-A- 20210 134 138
- US-A1- 2018 120 385

## Description

### TECHNICAL FIELD

The present application claims priority to Korean Patent Application No. 10-2022-0060635 filed on May 18, 2022 in the Republic of Korea.

The present disclosure relates to a battery SOH estimating apparatus and method, and more particularly, to a battery SOH estimating apparatus and method capable of more accurately estimating a SOH (State of health) of a battery.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-discharging rate and high energy density.

The battery capacity of such a battery decreases depending on the usage environment, usage period, the number of times of charging and discharging, etc. The state of health (SOH) of a battery is an index indicating how much the battery capacity has decreased from the initial battery capacity, and is one of the important parameters for evaluating the lifespan of a battery.

In general, the ampere counting method may be used to estimate the SOH of the battery. The ampere counting method is a method of estimating the SOH of a battery by measuring the battery capacity by the ampere counting method through full charge and full discharge, and comparing it with the initial battery capacity. This method may estimate the SOH of the battery very accurately if the variation of temperature or discharging rate may be properly compensated for, but it is not efficient because the battery must be fully charged and then fully discharged. In addition, when the offset is changed due to deterioration of a current sensor that measures the current of the battery, errors are accumulated during the ampere counting process, so the estimation result may be inaccurate.

Document US 2018/120385 discloses a battery aging state calculation method and device for calculating a SOH according to each execution operation and calculating a final battery SOH based on charge/discharge execution counts to improve the accuracy of the battery SOH.

Document EP 3 663 780 discloses a deterioration-state calculation method for calculating a deterioration state of a battery of the related art.

Document EP 3 273 523 discloses an apparatus for estimating a degree of aging of a secondary battery of known type.

### DISCLOSURE

### Technical Problem

The present disclosure is designed to solve the problems of the related art, and therefore the present disclosure is directed to providing a battery SOH estimating apparatus and method that may more accurately estimate the SOH of a battery by correcting the estimated SOH of the battery based on a SOC (State of charge) change amount, a SOC change region, and a temperature of the battery.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

A battery SOH estimating apparatus according to one aspect of the present invention is defined in the appended claims.

A battery pack according to another aspect of the present invention is also provided.

A vehicle according to still another aspect of the present invention is further provided.

A battery SOH estimating method according to another aspect of the present invention is provided.

### Advantageous Effects

According to one aspect of the present invention, the SOH of a battery may be more accurately estimated since various factors for the battery are considered.

The effects of the present invention are not limited to the above, and other effects not mentioned herein will be clearly understood by those skilled in the art from the appended claims.

### DESCRIPTION OF DRAWINGS

The accompanying drawings illustrate a preferred embodiment of the present invention and together with the foregoing disclosure, serve to provide further understanding of the technical features of the present disclosure, and thus, the present disclosure is not construed as being limited to the drawing.
FIG. 1 is a diagram schematically showing a battery SOH estimating apparatus according to an embodiment of the present invention.
FIG. 2 is a diagram schematically showing the SOH estimating process by the battery SOH estimating apparatus according to an embodiment of the present invention.
FIG. 3 is a diagram schematically showing a negative electrode differential profile of the battery.
FIG. 4 is a diagram schematically showing a positive electrode differential profile of the battery.
FIG. 5 is a diagram schematically showing an example of a SOC region factor table set in the battery SOH estimating apparatus according to an embodiment of the present invention.
FIG. 6 is a diagram schematically showing an example of a SOC change amount factor table set in the battery SOH estimating apparatus according to an embodiment of the present invention.
FIG. 7 is a diagram schematically showing an example of a temperature factor table set in a battery SOH estimating apparatus according to an embodiment of the present invention.
FIG. 8 is a diagram schematically showing an example of a C-rate factor table set in the battery SOH estimating apparatus according to an embodiment of the present invention.
FIG. 9 is a diagram schematically showing another example of the C-rate factor table set in the battery SOH estimating apparatus according to an embodiment of the present invention.
FIG. 10 is a diagram schematically showing an exemplary configuration of a battery pack according to another embodiment of the present invention.
FIG. 11 is a diagram schematically showing a battery SOH estimating method according to still another embodiment of the present invention.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, a preferred embodiment of the present disclosure will be described in detail with reference to the accompanying drawings.

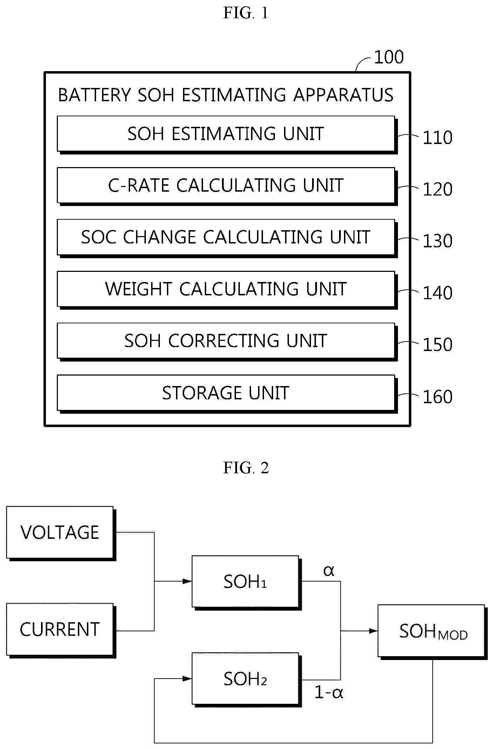

FIG. 1 is a diagram schematically showing a battery SOH estimating apparatus 100 according to an embodiment of the present invention.

Here, the battery refers to one physically separable independent cell having a negative electrode terminal and a positive electrode terminal. For example, a lithium-ion battery or a lithium polymer cell may be regarded as the battery. In addition, the battery may refer to a battery module in which a plurality of cells are connected in series and/or in parallel. Hereinafter, for convenience of description, the battery will be described as meaning one independent cell.

Referring to FIG. 1, the battery SOH estimating apparatus 100 includes a SOH estimating unit 110, a C-rate calculating unit 120, a SOC change calculating unit 130, a weight calculating unit 140 and a SOH correcting unit 150.

The SOH estimating unit 110 is configured to estimate a first SOH of a battery based on battery information including at least one of voltage, current and temperature of the battery.

For example, the SOH estimating unit 110 may receive battery information including at least one of voltage, current, and temperature of the battery from the outside or may store the battery information in advance. Preferably, the SOH estimating unit 110 may estimate the SOH based on battery information including all of voltage, current, and temperature of the battery.

As another example, the SOH estimating unit 110 may be configured to directly measure the voltage, current, and temperature of the battery.

Specifically, the SOH estimating unit 110 may be configured to estimate the first SOH in a present cycle based on the battery information in the present cycle.

For example, the SOH estimating unit 110 may estimate the first SOH of the battery based on the change in capacity of the battery. The SOH estimating unit 110 may estimate a corresponding state of charge (SOC) from the voltage of the battery.

Here, an SOC profile representing a corresponding relationship between the voltage of the battery and the SOC may be preset, and the SOH estimating unit 110 may estimate the corresponding SOC from the voltage of the battery based on the SOC profile. Alternatively, the SOC profile may be preset to represent a corresponding relationship among the voltage, temperature, and SOC of the battery. In this case, the SOH estimating unit 110 may estimate the SOC corresponding to the voltage and temperature of the battery based on the SOC profile.

In addition, the SOH estimating unit 110 may calculate the capacity of the battery based on the estimated SOC and the battery current. Thereafter, the SOH estimating unit 110 may estimate the first SOH of the battery by calculating a ratio between a preset criterion capacity and the calculated capacity for the battery. Here, the criterion capacity is a preset value of the capacity of a battery in a BOL (Beginning of life) state, and may be a capacity value corresponding to the OCV of the battery calculated by the SOH estimating unit 110.

As another example, the SOH estimating unit 110 may estimate the first SOH of the battery based on the change in internal resistance of the battery. The SOH estimating unit 110 may estimate the internal resistance of the battery from the voltage and current of the battery based on Ohm's law. In addition, the SOH estimating unit 110 may estimate the first SOH of the battery by calculating a ratio between a preset criterion resistance and the calculated internal resistance for the battery. Here, the criterion resistance may be a preset value of the internal resistance of a battery in a BOL state.

The first SOH of the battery estimated by the SOH estimating unit 110 may be an SOH value based on the voltage and current of the battery measured in the present cycle.

The C-rate calculating unit 120 is configured to calculate the charging and discharging C-rate for the battery based on the battery information. Here, C-rate may be an indicator representing the charge/discharge rate.

For example, the C-rate calculating unit 120 may receive information about the current flowing through the charging and discharging path (e.g., large current path) of the battery from the outside. Also, the C-rate calculating unit 120 may calculate the C-rate from the information about the current flowing through the charging and discharging path. Here, the information about the battery current obtained by the C-rate calculating unit 120 may be the same as the information about the battery current obtained by the SOH estimating unit 110.

As another example, the C-rate calculating unit 120 may directly measure the charging and discharging current of the battery and calculate the C-rate based on the measured charging and discharging current.

The SOC change calculating unit 130 is configured to calculate the SOC change region and the SOC change amount of the battery based on the battery information.

The SOC change calculating unit 130 is configured to calculate the SOC change region and the SOC change amount of the battery based on the voltage of the battery.

Specifically, the measured battery voltage is plural. Preferably, the voltage of the battery may be measured during charging and/or discharging, and includes a start voltage and an end voltage. In addition, the SOC change calculating unit 130 may estimate the SOC for the measured voltage (start voltage and end voltage) with reference to the SOC profile. The SOC change calculating unit 130 may calculate an SOC change region including the estimated SOC. Also, the SOC change calculating unit 130 may calculate the SOC change amount by calculating a difference between the estimated SOCs.

It is assumed that the measured battery voltages are V1 and V2, and the battery is charged from voltage V1 to voltage V2. The SOC change calculating unit 130 estimates SOC1 corresponding to the voltage V1 and SOC2 corresponding to the voltage V2, respectively. The SOC change calculating unit 130 calculates the SOC change region including SOC1 and SOC2 by setting the start SOC and the end SOC of the SOC change region to SOC1 and SOC2, respectively.

Also, the SOC change calculating unit 130 calculates the SOC change amount by calculating the formula of "|SOC2 - SOC1|". That is, the SOC change calculating unit 130 calculates the SOC change amount by calculating an absolute value of the SOC deviation of SOC2 and SOC1. Here, the SOC change amount may be expressed as ΔSOC, and may be calculated as a value of 0% or more and 100% or less.

The weight calculating unit 140 is configured to calculate the weight based on a C-rate factor based on the charging and discharging C-rate, a SOC region factor according to the comparison result between the SOC change region and a preset criterion SOC region, a SOC change amount factor based on the SOC change amount, and a temperature factor based on the measured temperature of the battery.

In addition, the weight calculating unit 140 may be configured to calculate the C-rate factor, the SOC region factor, the SOC change amount factor, and the temperature factor, respectively.

For example, the weight calculating unit 140 may receive the temperature of the battery from the outside or store the same in advance. Alternatively, the weight calculating unit 140 may be configured to directly measure the temperature of the battery.

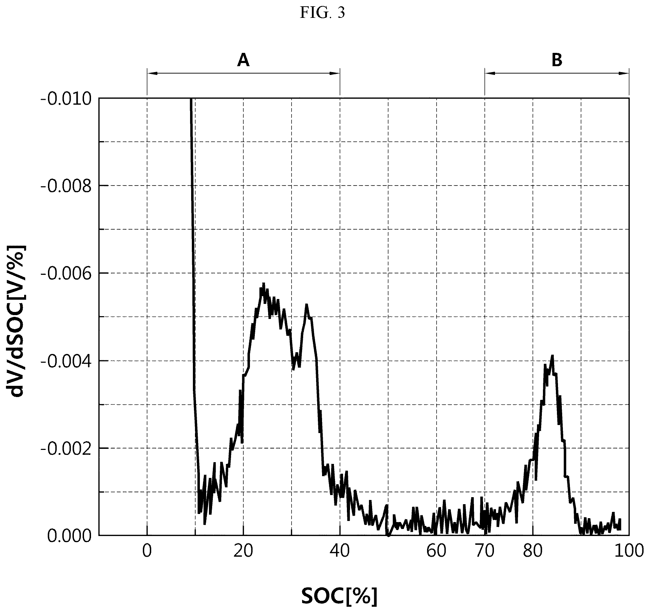

The SOC region factor may be calculated according to whether the preset criterion SOC region and the SOC change region calculated by the SOC change calculating unit 130 overlap. For example, the weight calculating unit may calculate the SOC region factor according to whether at least a part of the SOC change region belongs to the criterion SOC region. A specific embodiment of calculating the SOC region factor will be described later in detail with reference to FIGS. 3 to 5.

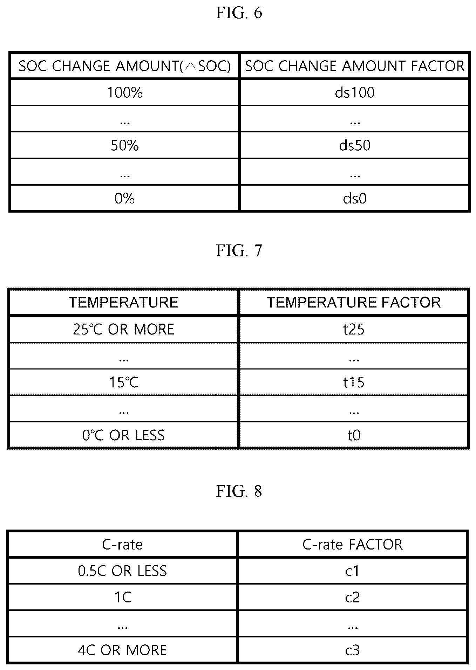

The SOC change amount factor is a factor calculated based on the SOC change amount calculated by the SOC change calculating unit 130. For example, the weight calculating unit 140 may calculate the SOC change amount factor to be proportional to the SOC change amount. A specific embodiment of calculating the SOC change amount factor will be described in detail later with reference to FIG. 6.

The temperature factor is a factor calculated based on the temperature of the battery. For example, the weight calculating unit 140 may calculate the temperature factor to be proportional to the temperature of the battery. A specific embodiment of calculating the temperature factor will be described later in detail with reference to FIG. 7.

The C-rate factor is a factor calculated based on the C-rate calculated by the C-rate calculating unit 120. For example, the weight calculating unit 140 may calculate the C-rate factor to be proportional to the calculated C-rate. A specific example in which the C-rate factor is calculated will be described in detail later with reference to FIG. 8.

The weight calculating unit 140 is configured to calculate a weight based on the C-rate factor, the SOC region factor, the SOC change amount factor, and the temperature factor. For example, the weight calculating unit 140 may be configured to calculate the weight by multiplying the C-rate factor, the SOC region factor, the SOC change amount factor, and the temperature factor. Here, the weight calculated by the weight calculating unit 140 may be set to have a value of 0 or more and 1 or less.

The SOH correcting unit 150 is configured to correct the first SOH according to the calculated weight and a preset second SOH.

Specifically, the SOH correcting unit 150 is configured to correct the first SOH according to the weight and a second SOH set before the present cycle. That is, the first SOH estimated by the SOH estimating unit 110 based on the battery information is corrected by the SOH correcting unit 150 based on the weight and the second SOH.

FIG. 2 is a diagram schematically showing the SOH estimating process by the battery SOH estimating apparatus 100 according to an embodiment of the present invention.

Referring to FIG. 2, the first SOH (SOH₁) is estimated based on the voltage and current of the battery. In addition, the first SOH (SOH₁) is corrected based on the second SOH (SOH₂) and the weight (α), and the corrected first SOH (SOH_{MOD}) is calculated.

For example, the SOH correcting unit 150 may be configured to correct the first SOH using the following equation. [Equation] ${SOH}_{MOD} = \left({SOH}_{1}\times α\right) + \left({SOH}_{2}\times \left(1-α\right)\right)$

Here, SOH_{MOD} is the corrected first SOH, SOH₁ is the first SOH, SOH₂ is the second SOH, and α is a weight that may be 0 or more and 1 or less.

In the embodiment according to the above equation, the SOH correcting unit 150 may multiply the first SOH (SOH₁) by the weight (α), and multiply the second SOH (SOH₂) by the complement (1-α) for the weight (α). In addition, the SOH correcting unit 150 may calculate the corrected first SOH (SOH_{MOD}) by adding the first SOH (SOH₁) multiplied by weight (α) and the second SOH (SOH₂) multiplied by the complement (1-α).

Referring to FIG. 2 further, the SOH estimating unit 110 is configured to estimate the first SOH (SOH₁) in the present cycle based on the battery information (e.g., at least one of voltage, current and temperature) corresponding to the present cycle.

For example, the SOH estimating unit 110 may estimate the first SOH (SOH₁) in the present cycle of the battery based on the battery information. In addition, the SOH correcting unit 150 is configured to correct the first SOH (SOH₁) according to the weight (α) and the second SOH (SOH₂) preset prior to the present cycle.

Also, referring to FIG. 2, the second SOH (SOH₂) is the first SOH (SOH_{MOD}) corrected in the previous cycle of the present cycle. That is, the corrected SOH (SOH_{MOD}) calculated in the present cycle is used as the second SOH (SOH₂) in the next cycle.

The battery SOH estimating apparatus 100 according to an embodiment of the present invention has an advantage of more accurately estimating the battery SOH by considering various factors such as the C-rate, SOC change region, SOC change amount and temperature.

In addition, as the charging and discharging cycle of the battery progresses, the battery SOH estimating apparatus 100 may recursively estimate the SOH of the battery in the present cycle by considering the SOH (second SOH) of the battery estimated in the previous cycle and the weight calculated in the present cycle, and thus has an advantage of improving the SOH estimation accuracy of the battery.

Meanwhile, the SOH estimating unit 110, the C-rate calculating unit 120, the SOC change calculating unit 130, the weight calculating unit 140 and the SOH correcting unit 150 included in the battery SOH estimating apparatus 100 may optionally include an application-specific integrated circuit (ASIC), another chipset, a logic circuit, a register, a communication modem, and a data processing device, and the like, known in the art to execute various control logics disclosed below.

In addition, the battery SOH estimating apparatus 100 may further include a storage unit 160. The storage unit 160 may store data necessary for operation and function of each component of the battery SOH estimating apparatus 100, data generated in the process of performing the operation or function, or the like. The storage unit 160 is not particularly limited in its kind as long as it is a known information storage means that can record, erase, update and read data. As an example, the information storage means may include RAM, flash memory, ROM, EEPROM, registers, and the like. In addition, the storage unit 160 may store program codes in which processes executable by the SOH estimating unit 110, the C-rate calculating unit 120, the SOC change calculating unit 130, the weight calculating unit 140 and the SOH correcting unit 150 are defined.

Hereinafter, an embodiment in which the SOC region factor is calculated based on the SOC change region will be described.

The weight calculating unit 140 may be configured to calculate the SOC region factor according to whether at least a part of the SOC change region belongs to the criterion SOC region.

Preferably, the criterion SOC region may be configured to include a plurality of SOC regions. Accordingly, the weight calculating unit 140 may be configured to calculate the SOC region factor according to whether at least a part of the SOC change region belongs to each of the plurality of SOC regions.

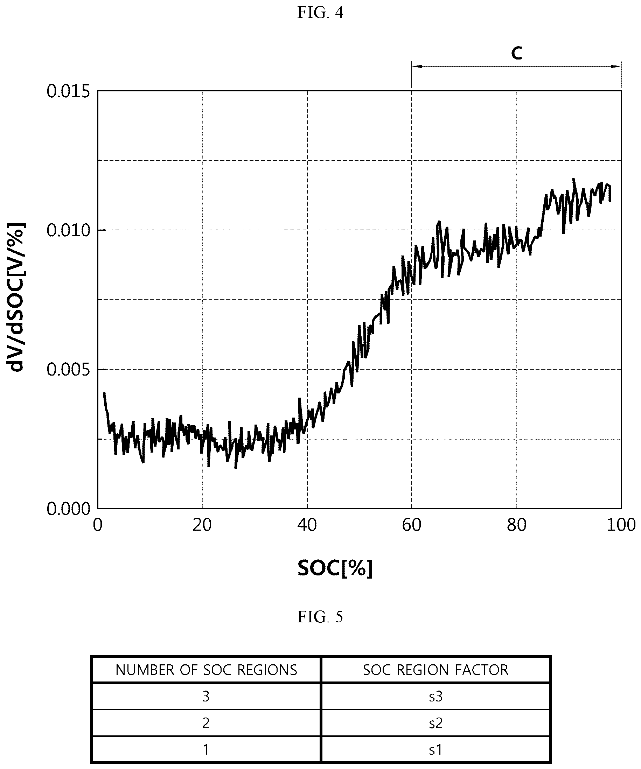

FIG. 3 is a diagram schematically showing a negative electrode differential profile of the battery. FIG. 4 is a diagram schematically showing a positive electrode differential profile of the battery.

The differential profile of FIGS. 3 and 4 is preset for a battery in a BOL state, and may be a differential profile representing a corresponding relationship between a differential voltage (dV/dSOC) for SOC and SOC. Specifically, the differential voltage may be an instantaneous change rate of the voltage (V) with respect to SOC. In addition, the differential profile may be expressed as an X-Y graph when X is SOC and Y is differential voltage (dV/dSOC).

In the negative electrode differential profile of the embodiment of FIG. 3, the intrinsic stress region of the negative electrode active material may appear in the SOC 0% to 40% region and the SOC 70% to 100% region. In addition, in the positive electrode differential profile of the embodiment of FIG. 4, the intrinsic stress region of the positive electrode active material may appear in the SOC 60% to 100% region.

Accordingly, the plurality of criterion SOC regions may be preset for each of the intrinsic stress region of the positive electrode active material and the intrinsic stress region of the negative electrode active material. For example, referring to FIGS. 3 and 4, the first criterion SOC region A may be set to the SOC 0% to 40% region, the second criterion SOC region B may be set to the SOC 70% to 100% region, and the third criterion SOC region C may be set to the SOC 60% to 100% region.

However, in the embodiments of FIGS. 3 and 4, a total of three criterion SOC regions are set for the battery, but it should be noted that the number and size of the criterion SOC regions may vary according to the change in the active material composition of the battery.

In addition, the weight calculating unit 140 may be configured to calculate the number of criterion SOC regions including at least a part of the SOC change regions among the plurality of SOC regions, and calculate the SOC region factor according to the calculated number.

FIG. 5 is a diagram schematically showing an example of a SOC region factor table set in the battery SOH estimating apparatus 100 according to an embodiment of the present invention. The number of criterion SOC regions and the SOC region factor included in the embodiment of FIG. 5 are only examples, and the present disclosure should not be construed as limited by the embodiment of FIG. 5.

Specifically, the SOC region factor table of FIG. 5 may be a look-up table in which the SOC region factor is preset according to the number of criterion SOC regions to which at least a part of the SOC change region of the battery belongs.

For example, the SOC region factor may be set to a value between 0 and 1. Preferably, the SOC region factor can be set to 1 when the SOC change region of the battery is entirely included in the criterion SOC region. Also, the remaining SOC region factors can be set according to the number of criterion SOC regions in which the SOC change region of the battery is included. For example, in the embodiment of FIG. 5, s3, s2, and s1 may be set to 1, 0.66, and 0.33, respectively.

For example, if at least a part of the SOC change region of the battery belongs to all of the first to third criterion SOC regions (A, B, C), the SOC region factor may be s3. For example, when the SOC change region of the battery is the SOC 30% to 80% region, at least a part of the SOC change regions (30% to 80%) of the battery may be all included in the first to third criterion SOC regions (A, B, C). Therefore, the SOC region factor for the battery may be set to s3.

As another example, if at least a part of the SOC change region of the battery belongs to only any two of the first to third criterion SOC regions (A, B, C), the SOC region factor may be s2. For example, when the SOC change region of the battery is the SOC 50% to 80% region, at least a part of the SOC change region (50% to 80%) of the battery may be included in the second and third criterion SOC regions (B, C). Therefore, the SOC region factor for the battery may be set to s2.

As still another example, if at least a part of the SOC change region of the battery belongs to only one of the first to third criterion SOC regions (A, B, C), the SOC region factor may be s1. For example, when the SOC change region of the battery is the SOC 30% to 50% region, at least a part of the SOC change region (30% to 50%) of the battery may be included in the first criterion SOC region (A). Therefore, the SOC region factor for the battery may be set to s1.

However, since the embodiment of FIG. 5 is an embodiment having three preset criterion SOC regions, it should be noted that if the number of preset criterion SOC regions is changed, the SOC region factor may also be changed accordingly. For example, unlike the embodiment of FIG. 5, it is assumed that five criterion SOC regions are set. In this case, the number of SOC regions to which at least a part of the SOC change region belongs may be 5, 4, 3, 2, or 1. The SOC region factor may be preset to s5 (the number of SOC regions belonging thereto is 5), s4 (the number of SOC regions belonging thereto is 4), s3 (the number of SOC regions belonging thereto is 3), s2 (the number of SOC regions belonging thereto is 2), and s1 (the number of SOC regions belonging thereto is 1).

In general, in the course of charging and discharging the battery, the degradation of the battery may be accelerated as the SOC of the battery is included in the intrinsic stress region of the positive electrode active material and/or the intrinsic stress region of the negative electrode active material. Therefore, the battery SOH estimating apparatus 100 according to an embodiment of the present invention has an advantage of calculating the SOC region factor in consideration of whether the degradation of the battery is accelerated according to the intrinsic stress region of the active material in order to more accurately estimate the battery SOH.

Hereinafter, an embodiment in which the SOC change amount factor is calculated based on the SOC change amount will be described.

The weight calculating unit 140 may be configured to calculate the SOC change amount factor to be proportional to the SOC change amount.

Specifically, the weight calculating unit 140 may be configured to calculate a SOC change amount factor corresponding to the SOC change amount calculated based on the preset SOC change amount factor table.

Here, the SOC change amount is a difference between the start SOC and the end SOC of the battery in one cycle, and is calculated as "|end SOC - start SOC|", and may be expressed as ΔSOC. Here "|x|" means an absolute value of x.

FIG. 6 is a diagram schematically showing an example of a SOC change amount factor table set in the battery SOH estimating apparatus 100 according to an embodiment of the present invention. The SOC change amount and the SOC change amount factor included in the embodiment of FIG. 6 are only examples, and the present invention should not be construed as limited by the embodiment of FIG. 6.

Specifically, the SOC change amount factor table of FIG. 6 may be a look-up table in which the SOC change amount factor is preset according to the SOC change amount of the battery.

Preferably, the SOC change amount factor may be preset to be proportional to the SOC change amount (ΔSOC) of the battery. In the embodiment of FIG. 6, the SOC change amount factor may be a value obtained by converting the SOC change amount (ΔSOC) to have a value of ds0 to ds100. For example, ds0 may correspond to 0, ds50 may correspond to 0.5, and ds100 may correspond to 1.

For example, as in the previous embodiment, it is assumed that the SOC change region of the battery is the SOC 30% to 80% region. In this case, the SOC change amount (ΔSOC) may be 50%. Accordingly, according to the SOC change amount factor table of FIG. 6, the SOC change amount factor for the battery may be set to ds50 (e.g., 0.5).

Hereinafter, an embodiment in which the temperature factor is calculated based on the temperature of the battery will be described.

The weight calculating unit 140 may be configured to calculate the temperature factor according to a region to which the temperature of the battery belongs among a plurality of preset temperature regions.

Specifically, the weight calculating unit 140 may be configured to calculate a temperature factor corresponding to the temperature of the battery based on a preset temperature factor table.

Here, the battery temperature may be an average temperature or a maximum temperature of the battery in one cycle.

FIG. 7 is a diagram schematically showing an example of a temperature factor table set in a battery SOH estimating apparatus 100 according to an embodiment of the present invention. The temperature and the temperature factor included in the embodiment of FIG. 7 are merely examples, and the present disclosure should not be construed as limited by the embodiment of FIG. 7.

Specifically, the temperature factor table of FIG. 7 may be a look-up table in which the temperature factor is preset according to the temperature of the battery. In addition, the temperature factor may be preset to be proportional to the temperature of the battery. For example, the temperature factor may be a value obtained by converting the temperature of the battery to have a value of t0 to t25.

For example, when the temperature of the battery is 25°C or higher, the temperature factor may be set to t25. When the temperature of the battery is 15°C, the temperature factor may be set to t15. When the temperature of the battery is 0°C or less, the temperature factor may be set to t0.

In addition, the temperature factor for the temperature of the battery not recorded in the temperature factor table may be calculated through the temperature of the battery and the temperature factor included in the temperature factor table. For example, the weight calculating unit 140 may calculate a temperature factor corresponding to a temperature of the battery not included in the temperature factor table by applying a method such as interpolation to the temperature factor table.

For example, in the embodiment of FIG. 7, it is assumed that t0, t15, and t25 are 0, 0.5, and 1, respectively. If the temperature of the battery is 3°C, 6°C, 9°C, 12°C, 18°C, 21°C, and 24°C, which are not included in the temperature factor table, the weight calculating unit 140 may calculate the temperature factor for each temperature as 0.1, 0.2, 0.3, 0.4, 0.8, and 0.95 by using the interpolation method.

Hereinafter, an embodiment in which the C-rate factor is calculated based on the charging and discharging C-rate will be described.

The weight calculating unit 140 may be configured to calculate the C-rate factor corresponding to the calculated charging and discharging C-rate based on a C-rate factor table preset to represent the corresponding relationship between the charging and discharging C-rate and the C-rate factor.

FIG. 8 is a diagram schematically showing an example of a C-rate factor table set in the battery SOH estimating apparatus 100 according to an embodiment of the present invention. The C-rate and the C-rate factor included in the embodiment of FIG. 8 are only examples, and the present disclosure should not be construed as limited by the embodiment of FIG. 8.

In the embodiment of FIG. 8, when the C-rate is 0.5C or less, the C-rate factor may be set to c1. If the C-rate is 0.5C or more and less than 4C, the C-rate factor may be set to correspond to each C-rate. If the C-rate is 4C or more, the C-rate factor may be set to c3. For example, in the embodiment of FIG. 8, the C-rate factor corresponding to 1C may be set to c2.

As another example, the C-rate factor may be set to correspond to the C-rate region to which the charging and discharging C-rate of the battery belongs. For example, in the embodiment of FIG. 8, when the C-rate is 0.5C or less, the C-rate factor may be set to c1. If the C-rate is more than 0.5C and 1C or less, the C-rate factor may be set to c2. If the C-rate is 4C or more, the C-rate factor may be set to c3.

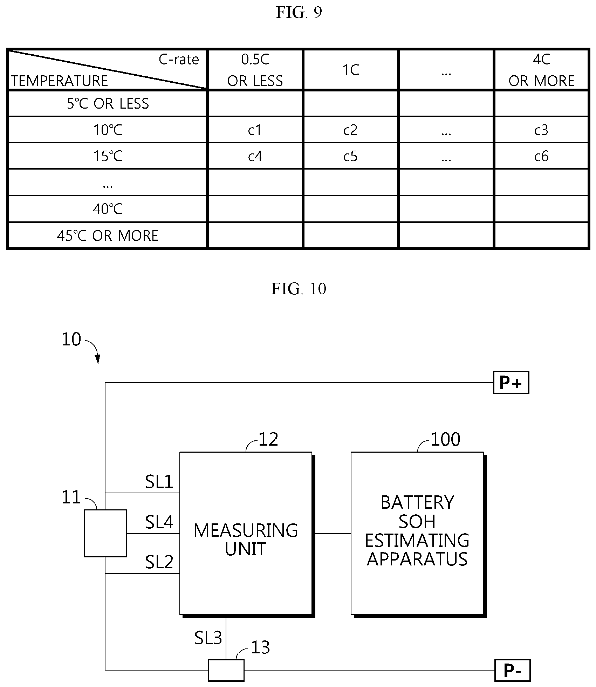

FIG. 9 is a diagram schematically showing another example of the C-rate factor table set in the battery SOH estimating apparatus 100 according to an embodiment of the present invention.

The weight calculating unit 140 may be configured to calculate the C-rate factor corresponding to the calculated C-rate and temperature based on a C-rate factor table preset to represent the C-rate factor according to the temperature of the battery and the charging and discharging C-rate.

In other words, the C-rate factor table may be configured to represent the C-rate factor according to the temperature of the battery and the charging and discharging C-rate. Specifically, the C-rate factor may be configured to be proportional to temperature and C-rate.

For example, in the embodiment of FIG. 9, it is assumed that the temperature of the battery is 10°C. When the charging and discharging C-rate is 0.5C or less, 1C, and 4C or more, the C-rate factor may be c1, c2, and c3, respectively. Here, the value of the C-rate factor may increase in the order of c1, c2, and c3.

As another example, in the embodiment of FIG. 9, it is assumed that the temperature of the battery is 15°C. When the charging and discharging C-rate is 0.5C or less, 1C, and 4C or more, the C-rate factor may be c4, c5, and c6, respectively. Here, the value of the C-rate factor may increase in the order of c4, c5, and c6.

Additionally, the value of c4 may be greater than c1, the value of c5 may be greater than c2, and the value of c6 may be greater than c3.

The battery SOH estimating apparatus 100 according to an embodiment of the present invention may calculate a weight based on the temperature of the battery, the SOC change amount, the SOC change region, and the charging and discharging C-rate. That is, the battery SOH estimating apparatus 100 has an advantage of more accurately estimating the SOH of the battery by considering various factors (temperature, SOC change amount, SOC change region, and charging and discharging C-rate) affecting the degradation of the battery. In particular, since the battery SOH estimating apparatus 100 considers the SOC change region factor caused by the intrinsic stress region of the active material, it has an advantage of reflecting the degradation acceleration factor of the battery in estimating the SOH of the battery.

The battery SOH estimating apparatus 100 according to the present invention may be applied to a battery management system (BMS). That is, the BMS according to the present invention may include the battery SOH estimating apparatus 100 described above. In this configuration, at least some of components of the battery SOH estimating apparatus 100 may be implemented by supplementing or adding functions of the components included in a conventional BMS. For example, the SOH estimating unit 110, the C-rate calculating unit 120, the SOC change calculating unit 130, the weight calculating unit 140, the SOH correcting unit 150 and the storage unit 160 of the battery SOH estimating apparatus 100 may be implemented as components of the BMS.

In addition, the battery SOH estimating apparatus 100 according to the present invention is provided to a battery pack. That is, the battery pack according to the present invention includes the above-described battery SOH estimating apparatus 100 and one or more battery cells. In addition, the battery pack may further include electrical components (a relay, a fuse and the like) and a case.

FIG. 10 is a diagram schematically showing an exemplary configuration of a battery pack according to another embodiment of the present invention.

The positive electrode terminal of the battery 11 may be connected to the positive electrode terminal P+ of the battery pack 10, and the negative electrode terminal of the battery 11 may be connected to the negative electrode terminal P- of the battery pack 10.

The measuring unit 12 may be connected to the first sensing line SL1, the second sensing line SL2, the third sensing line SL3 and the fourth sensing line SL4.

Specifically, the measuring unit 12 may be connected to the positive electrode terminal of the battery 11 through the first sensing line SL1, and may be connected to the negative electrode terminal of the battery 11 through the second sensing line SL2. The measuring unit 12 may measure the voltage of the battery 11 based on the voltage of the battery at each of the first sensing line SL1 and the second sensing line SL2.

In addition, the measuring unit 12 may be connected to the current measuring unit 13 through the third sensing line SL3. For example, the current measuring unit 13 may be an ammeter or a shunt resistor capable of measuring the charging current and the discharging current of the battery 11. The measuring unit 12 may calculate the charge amount by measuring the charging current of the battery 11 through the third sensing line SL3. Also, the measuring unit 12 may calculate the discharge amount by measuring the discharging current of the battery 11 through the third sensing line SL3.

Also, the measuring unit 12 may measure the temperature of the battery 11 through the fourth sensing line SL4.

The voltage, current and temperature of the battery 11 measured by the measuring unit 12 may be transmitted to the battery SOH estimating apparatus 100. The battery SOH estimating apparatus 100 may estimate the SOH of the battery 11 based on the voltage, current, and temperature of the battery 11 received from the measuring unit 12. In addition, the battery SOH estimating apparatus 100 may calculate a charging and discharging C-rate of the battery 11 based the current of the battery 11 received from the measuring unit 12.

Additionally, the battery SOH estimating apparatus 100 according to the present invention is provided in a vehicle. More specifically, the vehicle may be an electric vehicle that receives an operating power through a battery pack. Additionally, the vehicle may include a battery pack including the battery SOH estimating apparatus 100.

For example, in the process of charging and discharging (driving) a vehicle, the battery SOH estimating apparatus 100 has an advantage of estimating the SOH of the battery more accurately by considering various factors (temperature, SOC change amount, SOC change region, and charging and discharging C-rate) that affect deterioration of the battery.

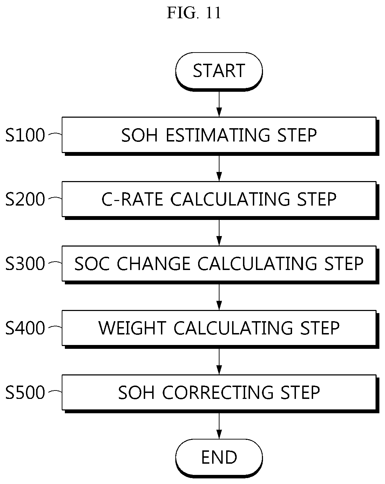

FIG. 11 is a diagram schematically showing a battery SOH estimating method according to still another embodiment of the present invention.

Preferably, each step of the battery SOH estimating method may be performed by the battery SOH estimating apparatus 100. Hereinafter, for convenience of explanation, the content overlapping with the previously described content will be omitted or briefly described.

Referring to FIG. 11, the SOH estimation method includes a SOH estimating step (S100), a C-rate calculating step (S200), a SOC change calculating step (S300), a weight calculating step (S400), and a SOH correcting step (S500).

The SOH estimating step (S100) is a step of estimating a first SOH of a battery based on battery information including at least one of voltage, current and temperature of the battery, and may be performed by the SOH estimating unit 110.

The C-rate calculating step (S200) is a step of calculating a charging and discharging C-rate for the battery based on the battery information, and may be performed by the C-rate calculating unit 120.

For example, the C-rate calculating unit 120 may calculate the charging and discharging C-rate of the battery based on information about a current flowing through the charging and discharging path (e.g., large current path) of the battery.

The SOC change calculating step (S300) is a step of calculating a SOC change region and a SOC change amount of the battery based on the voltage of the battery, and may be performed by the SOC change calculating unit 130.

The SOC change calculating unit 130 may calculate the SOC change region and the SOC change amount between the start SOC and the end SOC of the battery in one cycle, respectively.

For example, when the battery is charged from 30% SOC to 80% SOC, the SOC change calculating unit 130 may calculate the SOC change amount as 50% and calculate the SOC change region as the SOC 30% to 80% region.

For convenience of explanation, in the embodiment of FIG. 11, it is shown that the C-rate calculating step (S200) and the SOC change calculating step (S300) are performed after the SOH estimating step (S100), but it should be noted that the order of performing the SOH estimating step (S100), the C-rate calculating step (S200) and the SOC change calculating step (S300) is not limited to the embodiment of FIG. 11. For example, the SOH estimating step (S 100), the C-rate calculating step (S200) and the SOC change calculating step (S300) may be independently performed, respectively.

The weight calculating step (S400) is a step of calculating a weight based on a C-rate factor based on the charging and discharging C-rate, a SOC region factor according to the comparison result between the SOC change region and a preset criterion SOC region, a SOC change amount factor based on the SOC change amount, and a temperature factor based on the measured temperature of the battery, and may be performed by the weight calculating unit 140.

For example, the weight calculating unit 140 may calculate the C-rate factor for the charging and discharging C-rate calculated based on the C-rate factor table. Also, the weight calculating unit 140 may calculate the SOC region factor for the SOC change region based on the SOC region factor table. Also, the weight calculating unit 140 may calculate the SOC change amount factor for the SOC change amount based on the SOC change amount factor table. Also, the weight calculating unit 140 may calculate the temperature factor for the temperature of the battery based on the temperature factor table. In addition, the weight calculating unit 140 may calculate the weight by multiplying the calculated C-rate factor, the calculated SOC region factor, the calculated SOC change amount factor, and the calculated temperature factor.

The SOH correcting step (S500) is a step of correcting the first SOH according to the calculated weight and a preset second SOH, and may be performed by the SOH correcting unit 150.

For example, the SOH correcting unit 150 may correct the first SOH by adding a value obtained by multiplying the first SOH by a weight (α) and a value obtained by multiplying the second SOH by a complement (1-α) of the weight.

The battery SOH estimating method according to an embodiment of the present invention has an advantage of more accurately estimating SOH of the battery by considering various factors such as C-rate, SOC change region, SOC change amount, and temperature.

In addition, the battery SOH estimating method has an advantage of improving the SOH estimation accuracy by recursively estimating the SOH of the battery in the present cycle by considering the SOH of the battery estimated in the previous cycle and the weight calculated in the present cycle as the charging and discharging cycle of the battery progresses.

The embodiments of the present disclosure described above may not be implemented only through an apparatus and method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

In addition, since the present disclosure described above can be substituted, modified and changed in various ways by those skilled in the art without departing from the technical idea of the present disclosure, the present disclosure is not limited by the embodiments described above and the accompanying drawings, and all or some of the embodiments may be selectively combined to enable various modifications.

### (Explanation of reference signs)

10: battery pack
11: battery
12: measuring unit
13: current measuring unit
100: battery SOH estimating apparatus
110: SOH estimating unit
120: C-rate calculating unit
130: SOC change calculating unit
140: weight calculating unit
150: SOH correcting unit
160: storage unit

## Claims

1. A battery state of health, SOH, estimating apparatus (100), comprising:
a SOH estimating unit (110) configured to estimate a first SOH of a battery based on battery information including at least one of voltage, current and temperature of the battery;
a C-rate calculating unit (120) configured to calculate a charging and discharging C-rate for the battery based on the battery information;
a state of charge, SOC, change calculating unit (130) configured to calculate a SOC change region as interval between a start SOC (SOC1) corresponding to a first voltage (V1) and end SOC (SOC2) corresponding to a second voltage (V2) of the battery when charged from the first voltage (V1) to the second voltage (V2) and a SOC change amount calculated as absolute value of the difference between the end SOC (SOC2) and the first SOC (SOC1) of the battery based on the battery information;
a weight calculating unit (140) configured to calculate a weighting coefficient (α) based on a C-rate factor based on the charging and discharging C-rate, a SOC region factor according to the comparison result between the SOC change region and a preset criterion SOC region, a SOC change amount factor based on the SOC change amount, and a temperature factor based on the temperature of the battery; and
a SOH correcting unit (150) configured to correct the first SOH according to the calculated weighting coefficient (α) and a preset second SOH;
**characterized in that** the SOH estimating unit (110) is configured to estimate the first SOH in a present cycle based on the battery information in the present cycle, and
the SOH correcting unit (150) is configured to correct the first SOH according to the weighting coefficient (α) and the second SOH preset prior to the present cycle;
wherein the second SOH is the first SOH corrected in a previous cycle of the present cycle.

2. The battery SOH estimating apparatus (100) according to claim 1,
wherein the weight calculating unit (140) is configured to calculate the C-rate factor corresponding to the calculated charging and discharging C-rate based on a C-rate factor table preset to represent the corresponding relationship between the charging and discharging C-rate and the C-rate factor.

3. The battery SOH estimating apparatus (100) according to claim 1,
wherein the weight calculating unit (140) is configured to calculate the C-rate factor corresponding to the calculated C-rate and the temperature based on a C-rate factor table preset to represent the C-rate factor according to the temperature of the battery and the charging and discharging C-rate.

4. The battery SOH estimating apparatus according to claim 3,
wherein the C-rate factor is proportional to the temperature and the C-rate.

5. The battery SOH estimating apparatus (100) according to claim 1,
wherein the weight calculating unit (140) is configured to calculate the SOC region factor depending on whether at least a part of the SOC change region belongs to the criterion SOC region.

6. The battery SOH estimating apparatus (100) according to claim 5,
wherein the criterion SOC region is provided in plurality, and
wherein the weight calculating unit (140) is configured to calculate the number of SOC regions that include at least a part of the SOC change region among the criterion SOC regions, and calculate the SOC region factor corresponding to the calculated number of SOC regions based on a preset SOC region factor table.

7. The battery SOH estimating apparatus (100) according to claim 1,
wherein the weight calculating unit (140) is configured to calculate the SOC change amount factor corresponding to the calculated SOC change amount based on a preset SOC change amount factor table.

8. The battery SOH estimating apparatus (100) according to claim 1,
wherein the weight calculating unit (140) is configured to calculate the temperature factor corresponding to the temperature of the battery based on a preset temperature factor table.

9. The battery SOH estimating apparatus (100) according to claim 1,
wherein the weight calculating unit (140) is configured to calculate the weighting coefficient (α) by multiplying the C-rate factor, the SOC region factor, the SOC change amount factor, and the temperature factor.

10. The battery SOH estimating apparatus (100) according to claim 1, wherein the SOH correcting unit (150) is configured to correct the first SOH using the following equation, [Equation] ${SOH}_{MOD} = \left({SOH}_{1}\times α\right) + \left({SOH}_{2}\times \left(1-α\right)\right)$ where SOH_{MOD} is the corrected first SOH, SOH₁ is the first SOH, SOH₂ is the second SOH, and α is the weighting coefficient that is 0 or more and 1 or less.

11. A battery pack, comprising the battery SOH estimating apparatus (100) according to any one of claims 1 to 10.

12. A vehicle, comprising the battery SOH estimating apparatus (100) according to any one of claims 1 to 10.

13. A battery state of health, SOH, estimating method, comprising:
a providing step of providing a battery state of health, SOH, estimating apparatus (100) according to any of the preceding claims;
a SOH estimating step (S100) of estimating, by the apparatus (100), a first SOH of a battery based on battery information including at least one of voltage, current and temperature of the battery;
a C-rate calculating step (S200) of calculating, by the apparatus (100), a charging and discharging C-rate for the battery based on the battery information;
a state of charge, SOC, change calculating step (S300) of calculating, by the apparatus (100), a SOC change region as interval between a start SOC (SOC1) corresponding to a first voltage (V1) and end SOC (SOC2) corresponding to a second voltage (V2) of the battery when charged from the first voltage (V1) to the second voltage (V2) and a SOC change amount calculated as absolute value of the difference between the end SOC (SOC2) and the first SOC (SOC1) of the battery based on the battery information;
a weight calculating step (S400) of calculating, by the apparatus (100), a weighting coefficient (α) based on a C-rate factor based on the charging and discharging C-rate, a SOC region factor according to the comparison result between the SOC change region and a preset criterion SOC region, a SOC change amount factor based on the SOC change amount, and a temperature factor based on the temperature of the battery; and
a SOH correcting step (S500) of correcting, by the apparatus (100), the first SOH according to the calculated weighting coefficient (α) and a preset second SOH;
**characterized in that** the SOH estimating step comprises estimating step of estimating the first SOH in a present cycle based on the battery information in the present cycle, and
the SOH correcting step comprises correcting step of correcting the first SOH according to the weighting coefficient (α) and the second SOH preset prior to the present cycle;
wherein the second SOH is the first SOH corrected in a previous cycle of the present cycle.

## Patentansprüche

1. Vorrichtung zur Schätzung des Gesundheitszustands, SOH, einer Batterie (100), umfassend:
• eine SOH-Schätzeinheit (110), die konfiguriert ist, um einen ersten SOH einer Batterie auf der Grundlage von Batterieinformationen zu schätzen, einschließlich mindestens eines aus Spannung, Strom und Temperatur der Batterie;
• eine C-Rate-Berechnungseinheit (120), die konfiguriert ist, um eine Lade- und Entlade-C-Rate für die Batterie auf der Grundlage der Batterieinformationen zu berechnen;
• eine Berechnungseinheit für die Änderung des Ladezustands, SOC, (130), die konfiguriert ist, um einen SOC-Änderungsbereich als Intervall zwischen einem Anfangs-SOC (SOC₁) entsprechend einer ersten Spannung (V₁) und einem End-SOC (SOC₂) entsprechend einer zweiten Spannung (V₂) der Batterie, wenn sie von der ersten Spannung (V₁) auf die zweite Spannung (V₂) geladen wird, und einen SOC-Änderungsbetrag, der als Absolutwert der Differenz zwischen dem End-SOC (SOC₂) und dem ersten SOC (SOC₁) der Batterie berechnet wird, auf der Grundlage der Batterieinformationen zu berechnen;
• eine Gewichtsberechnungseinheit (140), die konfiguriert ist, um einen Gewichtungskoeffizienten (α) auf der Grundlage eines C-Rate-Faktors auf der Grundlage der Lade- und Entlade-C-Rate, eines SOC-Bereichsfaktors gemäß dem Vergleichsergebnis zwischen dem SOC-Änderungsbereich und einem voreingestellten Kriteriums-SOC-Bereich, eines SOC-Änderungsbetragsfaktors auf der Grundlage des SOC-Änderungsbetrags und eines Temperaturfaktors auf der Grundlage der Temperatur der Batterie zu berechnen; und
• eine SOH-Korrektureinheit (150), die konfiguriert ist, um den ersten SOH gemäß dem berechneten Gewichtungskoeffizienten (α) und einem voreingestellten zweiten SOH zu korrigieren;
**dadurch gekennzeichnet, dass** die SOH-Schätzeinheit (110) konfiguriert ist, um den ersten SOH in einem aktuellen Zyklus auf der Grundlage der Batterieinformationen im aktuellen Zyklus zu schätzen, und
die SOH-Korrektureinheit (150) konfiguriert ist, um den ersten SOH gemäß dem Gewichtungskoeffizienten (α) und dem vor dem aktuellen Zyklus voreingestellten zweiten SOH zu korrigieren;
wobei der zweite SOH der erste SOH ist, der in einem vorherigen Zyklus des aktuellen Zyklus korrigiert wurde.

2. Vorrichtung zur Schätzung des Batterie-SOH (100) nach Anspruch 1,
wobei die Gewichtsberechnungseinheit (140) konfiguriert ist, um den C-Rate-Faktor entsprechend der berechneten Lade- und Entlade-C-Rate auf der Grundlage einer C-Rate-Faktortabelle zu berechnen, die voreingestellt ist, um die entsprechende Beziehung zwischen der Lade- und Entlade-C-Rate und dem C-Rate-Faktor darzustellen.

3. Vorrichtung zur Schätzung des Batterie-SOH (100) nach Anspruch 1,
wobei die Gewichtsberechnungseinheit (140) konfiguriert ist, um den C-Rate-Faktor entsprechend der berechneten C-Rate und der Temperatur auf der Grundlage einer C-Rate-Faktortabelle zu berechnen, die voreingestellt ist, um den C-Rate-Faktor gemäß der Temperatur der Batterie und der Lade- und Entlade-C-Rate darzustellen.

4. Vorrichtung zur Schätzung des Batterie-SOH (100) nach Anspruch 3,
wobei der C-Rate-Faktor proportional zu der Temperatur und der C-Rate ist.

5. Vorrichtung zur Schätzung des Batterie-SOH (100) nach Anspruch 1,
wobei die Gewichtsberechnungseinheit (140) konfiguriert ist, um den SOC-Bereichsfaktor in Abhängigkeit davon zu berechnen, ob mindestens ein Teil des SOC-Änderungsbereichs zu dem Kriteriums-SOC-Bereich gehört.

6. Vorrichtung zur Schätzung des Batterie-SOH (100) nach Anspruch 5,
wobei der Kriteriums-SOC-Bereich in einer Vielzahl bereitgestellt ist, und
wobei die Gewichtsberechnungseinheit (140) konfiguriert ist, um die Anzahl der SOC-Bereiche zu berechnen, die mindestens einen Teil des SOC-Änderungsbereichs unter den Kriteriums-SOC-Bereichen umfassen, und den SOC-Bereichsfaktor entsprechend der berechneten Anzahl von SOC-Bereichen auf der Grundlage einer voreingestellten SOC-Bereichsfaktortabelle berechnet.

7. Vorrichtung zur Schätzung des Batterie-SOH (100) nach Anspruch 1,
wobei die Gewichtsberechnungseinheit (140) konfiguriert ist, um den SOC-Änderungsbetragsfaktor entsprechend dem berechneten SOC-Änderungsbetrag auf der Grundlage einer voreingestellten SOC-Änderungsbetragsfaktortabelle zu berechnen.

8. Vorrichtung zur Schätzung des Batterie-SOH (100) nach Anspruch 1,
wobei die Gewichtsberechnungseinheit (140) konfiguriert ist, um den Temperaturfaktor entsprechend der Temperatur der Batterie auf der Grundlage einer voreingestellten Temperaturfaktortabelle zu berechnen.

9. Vorrichtung zur Schätzung des Batterie-SOH (100) nach Anspruch 1,
wobei die Gewichtsberechnungseinheit (140) konfiguriert ist, um den Gewichtungskoeffizienten (α) durch Multiplizieren des C-Rate-Faktors, des SOC-Bereichsfaktors, des SOC-Änderungsbetragsfaktors und des Temperaturfaktors zu berechnen.

10. Vorrichtung zur Schätzung des Batterie-SOH (100) nach Anspruch 1,
wobei die SOH-Korrektureinheit (150) konfiguriert ist, um den ersten SOH unter Verwendung der folgenden Gleichung zu korrigieren, [Gleichung] ${SOH}_{MOD} = \left({SOH}_{1}\times α\right) + \left({SOH}_{2}\times \left(1-α\right)\right)$
wobei SOH_{MOD} der korrigierte erste SOH ist, SOH₁ der erste SOH ist, SOH₂ der zweite SOH ist und α der Gewichtungskoeffizient ist, der 0 oder mehr und 1 oder weniger beträgt.

11. Batteriepack, umfassend die Vorrichtung zur Schätzung des Batterie-SOH (100) nach einem der Ansprüche 1 bis 10.

12. Fahrzeug, umfassend die Vorrichtung zur Schätzung des Batterie-SOH (100) nach einem der Ansprüche 1 bis 10.

13. Verfahren zur Schätzung eines Gesundheitszustands, SOH, einer Batterie, umfassend:
• einen Bereitstellungsschritt des Bereitstellens einer Vorrichtung zur Schätzung des Gesundheitszustands, SOH, einer Batterie (100) nach einem der vorhergehenden Ansprüche;
• einen SOH-Schätzschritt (S100) des Schätzens, durch die Vorrichtung (100), eines ersten SOH einer Batterie auf der Grundlage von Batterieinformationen, einschließlich mindestens eines aus Spannung, Strom und Temperatur der Batterie;
• einen C-Rate-Berechnungsschritt (S200) des Berechnens, durch die Vorrichtung (100), einer Lade- und Entlade-C-Rate für die Batterie auf der Grundlage der Batterieinformationen;
• einen Ladezustandsänderungs-Berechnungsschritt, SOC, Änderungs-Berechnungsschritt (S300) des Berechnens, durch die Vorrichtung (100), eines SOC-Änderungsbereichs als Intervall zwischen einem Anfangs-SOC (SOC₁) entsprechend einer ersten Spannung (V₁) und einem End-SOC (SOC₂) entsprechend einer zweiten Spannung (V₂) der Batterie, wenn sie von der ersten Spannung (V₁) auf die zweite Spannung (V₂) geladen wird, und eines SOC-Änderungsbetrags, der als Absolutwert der Differenz zwischen dem End-SOC (SOC₂) und dem ersten SOC (SOC₁) der Batterie berechnet wird, auf der Grundlage der Batterieinformationen;
• einen Gewichtsberechnungsschritt (S400) des Berechnens, durch die Vorrichtung (100), eines Gewichtungskoeffizienten (α) auf der Grundlage eines C-Rate-Faktors auf der Grundlage der Lade- und Entlade-C-Rate, eines SOC-Bereichsfaktors gemäß dem Vergleichsergebnis zwischen dem SOC-Änderungsbereich und einem voreingestellten Kriteriums-SOC-Bereich, eines SOC-Änderungsbetragsfaktors auf der Grundlage des SOC-Änderungsbetrags und eines Temperaturfaktors auf der Grundlage der Temperatur der Batterie; und
• einen SOH-Korrekturschritt (S500) des Korrigierens, durch die Vorrichtung (100), des ersten SOH gemäß dem berechneten Gewichtungskoeffizienten (α) und einem voreingestellten zweiten SOH;
**dadurch gekennzeichnet, dass** der SOH-Schätzschritt einen Schätzschritt des Schätzens des ersten SOH in einem aktuellen Zyklus auf der Grundlage der Batterieinformationen im aktuellen Zyklus umfasst, und
der SOH-Korrekturschritt einen Korrekturschritt des Korrigierens des ersten SOH gemäß dem Gewichtungskoeffizienten (α) und dem vor dem aktuellen Zyklus voreingestellten zweiten SOH umfasst;
wobei der zweite SOH der erste SOH ist, der in einem vorherigen Zyklus des aktuellen Zyklus korrigiert wurde.

## Revendications

1. Appareil d'estimation de l'état de santé, SOH, d'une batterie (100), comprenant :
• une unité d'estimation de SOH (110) configurée pour estimer un premier SOH d'une batterie sur la base d'informations de batterie comprenant au moins l'un parmi une tension, un courant et une température de la batterie ;
• une unité de calcul de C-rate (120) configurée pour calculer un C-rate de charge et de décharge pour la batterie sur la base des informations de batterie ;
• une unité de calcul de changement d'état de charge, SOC (130) configurée pour calculer une région de changement de SOC sous la forme d'un intervalle entre un SOC de début (SOC₁) correspondant à une première tension (V₁) et un SOC de fin (SOC₂) correspondant à une seconde tension (V₂) de la batterie lorsqu'elle est chargée de la première tension (V₁) à la seconde tension (V₂) et une quantité de changement de SOC calculée sous la forme d'une valeur absolue de la différence entre le SOC de fin (SOC₂) et le premier SOC (SOC₁) de la batterie sur la base des informations de batterie ;
• une unité de calcul de poids (140) configurée pour calculer un coefficient de pondération (α) sur la base d'un facteur de C-rate basé sur le C-rate de charge et de décharge, d'un facteur de région de SOC selon le résultat de comparaison entre la région de changement de SOC et une région de SOC de critère prédéfinie, d'un facteur de quantité de changement de SOC basé sur la quantité de changement de SOC, et d'un facteur de température basé sur la température de la batterie ; et
• une unité de correction de SOH (150) configurée pour corriger le premier SOH selon le coefficient de pondération (α) calculé et un second SOH prédéfini ;
**caractérisé en ce que** l'unité d'estimation de SOH (110) est configurée pour estimer le premier SOH dans un cycle actuel sur la base des informations de batterie dans le cycle actuel, et
l'unité de correction de SOH (150) est configurée pour corriger le premier SOH selon le coefficient de pondération (α) et le second SOH prédéfini avant le cycle actuel ;
dans lequel le second SOH est le premier SOH corrigé dans un cycle précédent du cycle actuel.

2. Appareil d'estimation de SOH de batterie (100) selon la revendication 1,
dans lequel l'unité de calcul de poids (140) est configurée pour calculer le facteur de C-rate correspondant au C-rate de charge et de décharge calculé sur la base d'une table de facteurs de C-rate prédéfinie pour représenter la relation de correspondance entre le C-rate de charge et de décharge et le facteur de C-rate.

3. Appareil d'estimation de SOH de batterie (100) selon la revendication 1,
dans lequel l'unité de calcul de poids (140) est configurée pour calculer le facteur de C-rate correspondant au C-rate calculé et à la température sur la base d'une table de facteurs de C-rate prédéfinie pour représenter le facteur de C-rate selon la température de la batterie et le C-rate de charge et de décharge.

4. Appareil d'estimation de SOH de batterie (100) selon la revendication 3,
dans lequel le facteur de C-rate est proportionnel à la température et au C-rate.

5. Appareil d'estimation de SOH de batterie (100) selon la revendication 1,
dans lequel l'unité de calcul de poids (140) est configurée pour calculer le facteur de région de SOC selon qu'au moins une partie de la région de changement de SOC appartient à la région de SOC de critère.

6. Appareil d'estimation de SOH de batterie (100) selon la revendication 5,
dans lequel la région de SOC de critère est fournie en pluralité, et
dans lequel l'unité de calcul de poids (140) est configurée pour calculer le nombre de régions de SOC qui comprennent au moins une partie de la région de changement de SOC parmi les régions de SOC de critère, et calculer le facteur de région de SOC correspondant au nombre calculé de régions de SOC sur la base d'une table de facteurs de région de SOC prédéfinie.

7. Appareil d'estimation de SOH de batterie (100) selon la revendication 1,
dans lequel l'unité de calcul de poids (140) est configurée pour calculer le facteur de quantité de changement de SOC correspondant à la quantité de changement de SOC calculée sur la base d'une table de facteurs de quantité de changement de SOC prédéfinie.

8. Appareil d'estimation de SOH de batterie (100) selon la revendication 1,
dans lequel l'unité de calcul de poids (140) est configurée pour calculer le facteur de température correspondant à la température de la batterie sur la base d'une table de facteurs de température prédéfinie.

9. Appareil d'estimation de SOH de batterie (100) selon la revendication 1,
dans lequel l'unité de calcul de poids (140) est configurée pour calculer le coefficient de pondération (α) en multipliant le facteur de C-rate, le facteur de région de SOC, le facteur de quantité de changement de SOC et le facteur de température.

10. Appareil d'estimation de SOH de batterie (100) selon la revendication 1,
dans lequel l'unité de correction de SOH (150) est configurée pour corriger le premier SOH en utilisant l'équation suivante, [Equation] ${SOH}_{MOD} = \left({SOH}_{1}\times α\right) + \left({SOH}_{2}\times \left(1-α\right)\right)$
où SOH_{MOD} est le premier SOH corrigé, SOH₁ est le premier SOH, SOH₂ est le second SOH, et α est le coefficient de pondération qui vaut 0 ou plus et 1 ou moins.

11. Bloc-batterie, comprenant l'appareil d'estimation de SOH de batterie (100) selon l'une quelconque des revendications 1 à 10.

12. Véhicule, comprenant l'appareil d'estimation de SOH de batterie (100) selon l'une quelconque des revendications 1 à 10.

13. Procédé d'estimation d'un état de santé, SOH, d'une batterie, comprenant :
• une étape de fourniture consistant à fournir un appareil d'estimation d'état de santé, SOH, de batterie (100) selon l'une quelconque des revendications précédentes ;
• une étape d'estimation de SOH (S100) consistant à estimer, par l'appareil (100), un premier SOH d'une batterie sur la base d'informations de batterie comprenant au moins l'un parmi une tension, un courant et une température de la batterie ;
• une étape de calcul de C-rate (S200) consistant à calculer, par l'appareil (100), un C-rate de charge et de décharge pour la batterie sur la base des informations de batterie ;
• une étape de calcul de changement d'état de charge, SOC (S300) consistant à calculer, par l'appareil (100), une région de changement de SOC sous la forme d'un intervalle entre un SOC de début (SOC₁) correspondant à une première tension (V₁) et un SOC de fin (SOC₂) correspondant à une seconde tension (V₂) de la batterie lorsqu'elle est chargée de la première tension (V₁) à la seconde tension (V₂) et une quantité de changement de SOC calculée sous la forme d'une valeur absolue de la différence entre le SOC de fin (SOC₂) et le premier SOC (SOC₁) de la batterie sur la base des informations de batterie ;
• une étape de calcul de poids (S400) consistant à calculer, par l'appareil (100), un coefficient de pondération (α) sur la base d'un facteur de C-rate basé sur le C-rate de charge et de décharge, d'un facteur de région de SOC selon le résultat de comparaison entre la région de changement de SOC et une région de SOC de critère prédéfinie, d'un facteur de quantité de changement de SOC basé sur la quantité de changement de SOC, et d'un facteur de température basé sur la température de la batterie ; et
• une étape de correction de SOH (S500) consistant à corriger, par l'appareil (100), le premier SOH selon le coefficient de pondération (α) calculé et un second SOH prédéfini ;
**caractérisé en ce que** l'étape d'estimation de SOH comprend une étape d'estimation consistant à estimer le premier SOH dans un cycle actuel sur la base des informations de batterie dans le cycle actuel, et
l'étape de correction de SOH comprend une étape de correction consistant à corriger le premier SOH selon le coefficient de pondération (α) et le second SOH prédéfini avant le cycle actuel ;
dans lequel le second SOH est le premier SOH corrigé dans un cycle précédent du cycle actuel.
